# DEMANDE DE BREVET EUROPEEN

(11) **EP 1 112 981 A1**
(43) Date de publication de la demande: **04.07.2001**
(21) Numéro de dépôt: 00401800.8
(22) Date de dépôt: 23.06.2000
(51) Int. Cl.: C03C 17/23, C03C 17/34, G02B 1/10, C03C 17/245, G02B 1/11, C23C 14/08, C23C 14/24

(54) **Procédé de préparation d'un revêtement optique sur un substrat par évaporation sous vide d'une poudre**

(30) Priorité: 30.12.1999 FR 9916758
(71) Demandeur: Couget, Norbert, 91160 Longjumeau (FR)
(72) Inventeur: Couget, Norbert, 91160 Longjumeau (FR)
(74) Mandataire: Audier, Philippe André

(57) **Abrégé**

Procédé de préparation d'un revêtement optique, en particulier d'un revêtement antireflets, sur un substrat, dans lequel on dépose au moins une des couches dudit revêtement par évaporation sous vide d'une poudre, ladite poudre étant constituée d'un mélange de poudre de silicium et de poudre de silice.

## Description

L'invention concerne un procédé de préparation d'un revêtement optique sur un substrat, par évaporation sous vide d'une poudre.

En particulier, l'invention concerne la préparation de revêtements à propriétés optiques comprenant au moins une couche à base d'oxyde de silicium SiO, ou SiₓO_{y}, par exemple SiO₂.

Les matériaux antireflets et les matériaux réfléchissants sont composés d'un substrat organique ou inorganique, recouvert de plusieurs couches dont certaines présentent les propriétés optiques spécifiques recherchées.

Les matériaux antireflets ou réfléchissants présentent une multitude d'applications.

Ainsi, les substrats organiques ou inorganiques, c'est-à-dire notamment les plastiques ou les substrats vitreux, revêtus d'un film antireflet présentent un intérêt tout particulier dans les domaines tels que celui des produits ophtalmiques et des écrans, tels que les écrans de visualisation, ou les applications architecturales, comme les panneaux vitrés placés à l'extérieur ou à l'intérieur des bâtiments et, plus généralement, dans celui de l'optique.

Dans la présente demande, nous nous intéresserons, de préférence, aux matériaux optiques utilisés dans le secteur ophtalmique, tels que verres de lunetterie, lentilles, etc.. Les substrats, mis en oeuvre dans ce domaine, sont, en particulier, des plastiques, tels que les polycarbonates, les polyacrylates, les polyalkylcarbonates et autres, mais aussi des verres minéraux.

Les revêtements antireflets à large bande spectrale ont longtemps compris deux couches, jusqu'à l'apparition des revêtements à trois couches. Un tel revêtement, appliqué sur un substrat ou support, de préférence, organique, mais aussi inorganique, comprend généralement une superposition de trois couches, qui sont, à partir du substrat ou support, une couche d'épaisseur ¼ de largeur d'onde λ et d'indice de réfraction moyen ou médian, c'est-à-dire généralement d'environ 1,60 à 1,70, puis une couche d'épaisseur ½ de longueur d'onde λ et de fort indice de réfraction, c'est-à-dire généralement d'environ 1,8 à 2,2 ; et une couche supérieure, d'épaisseur ¼ de longueur d'onde et d'indice de réfraction faible ou bas, c'est-à-dire généralement d'environ 1,42 à 1,45.

En fait, le plus souvent, la couche d'indice de réfraction moyen ou médian est constituée par la combinaison de deux sous-couches d'indices respectivement haut et bas, tandis que les couches de fort et faible indices de réfraction sont constituées de produits purs, par exemple d'oxyde de titane et de quartz.

En outre, si le substrat est un substrat organique ou verre plastique, il faut veiller à utiliser soit une matière peu déformable, c'est-à-dire à faible coefficient de dilatation thermique, soit un support plastique préalablement revêtu d'un vernis ou couche d'accroche, permettant d'assurer la transition entre les coefficients de dilatation thermique de la première couche de revêtement et du substrat. Ce vernis sera, par exemple, un vernis silicié permettant le pontage, un vernis de type polysiloxane, ou bien sera constitué de grains de silice enrobés dans un polymère. Un tel revêtement antireflets comprend généralement, sur la couche à faible indice de réfraction, une couche antiabrasive, de préférence, à base d'un silane fluoré.

La préparation de couche ou de revêtements multicouches, lorsqu'ils étaient déposés sur des substrats ou supports minéraux (verres minéraux) a été essentiellement effectuée par un procédé d'évaporation sous vide à partir de poudres des composés à déposer, placées dans une nacelle ou creuset. Des couches et revêtements multicouches de MgF₂ et d'oxydes métalliques, tels que les oxydes de chrome, de titane, ont ainsi pu être déposés de la sorte sur des verres minéraux.

Lorsque de tels couches ou de tels revêtements ont du être déposés sur des substrats ou supports plastiques, l'adaptation des coefficients de dilatation a nécessité la mise en oeuvre de silice SiO₂.

Il s'est avéré alors que la silice SiO₂ ne pouvait s'évaporer dans une nacelle. En effet, la silice produit une réaction avec le métal constituant le creuset, par exemple le molybdène ou le tantale, qui aboutit à la détérioration de la nacelle, voire au perçage de celle-ci. En outre, cette réaction entre le métal de la nacelle et la silice conduit à la formation de composés évaporés impurs conduisant de même à des dépôts impurs ne correspondant pas aux qualités physiques requises.

C'est la raison pour laquelle, le dépôt de couches de silice ou de revêtements multicouches, comprenant de la silice (quartz) sur des substrats ou supports organiques (verres plastiques), a été effectué principalement par deux méthodes physiques de dépôt sous vide.

La première de ces méthodes est le dépôt sous vide avec utilisation d'un canon à électrons ; elle présente l'avantage d'une haute température d'évaporation et donc d'une bonne évaporation du quartz, sans amalgame avec la nacelle d'évaporation, mais elle met en oeuvre de très hautes tensions, elle est d'un coût élevé, lié à sa forte consommation d'énergie, et le canon à électrons est difficile à exploiter par un personnel non qualifié.

La deuxième de ces méthodes est la pulvérisation cathodique (« sputtering » en anglais), dans laquelle on évite l'utilisation d'un canon à électrons et où l'épaisseur des couches peut être facilement maîtrisée, puisqu'elle est théoriquement fonction du temps. Une telle méthode et un appareil pour sa mise en oeuvre sont, par exemple, décrits dans le document WO-A-92 13114. La méthode de pulvérisation cathodique comporte cependant un certain nombres d'inconvénients : la pulvérisation n'est pas dirigée et se produit dans tous les sens, il faut donc, par exemple, masquer la face arrière du verre avec un adhésif. Il faut, en outre, se placer à une certaine distance du substrat car il y a une modification de la géométrie de l'électrode au cours du temps, ce qui entraîne un changement de l'homogénéité, ainsi que du parallélisme des couches déposées.

Enfin, la compacité des couches préparées par cette méthode de pulvérisation cathodique est très grande et elles sont donc très sensibles au coefficient de dilatation des couches déposées sur un verre plastique.

Le procédé de pulvérisation cathodique est, en conséquence, globalement peu satisfaisant, bien qu'il permette de s'affranchir des hautes tensions, et qu'il n'implique pas de manipulation, sauf pour les cibles.

D'autres procédés pour le dépôt de revêtement, tels que des revêtements antireflets, sont les procédés de dépôt par voie chimique douce et, en particulier, les procédés sol-gel, qu'il s'agisse des procédés polymériques ou des procédés colloïdaux.

Ces procédés donnent souvent des revêtements défectueux liés aux contraintes auxquelles sont soumises les couches épaisses conduisant ainsi à un craquèlement.

Il ressort de ce qui précède qu'il existe un besoin non encore satisfait pour un procédé de préparation de couches de silice ou d'un revêtement à base de silice sur un substrat, en particulier un substrat organique (verre plastique ou organique), qui permette, entre autres, le dépôt de telles couches ou revêtement, de manière simple, avec une grande sûreté, à l'aide d'un appareil peu onéreux, facile à mettre en oeuvre, même par des opérateurs peu qualifié.

Le procédé doit également permettre d'obtenir des couches déposées présentant d'excellentes propriétés optiques, de résistances mécaniques, et d'adhésion, d'une part, entre couche et substrat et, d'autre part, entre couches.

L'invention a donc pour but de répondre, entre autres, à l'ensemble des besoins, mentionnés ci-dessus, et de fournir un procédé de préparation d'un revêtement optique sur un substrat ou support, qui ne présente pas les inconvénients, défauts, limitations et désavantages des procédés de l'art antérieur, en particulier des procédés de dépôt, à l'aide d'un canon à électrons, ou par pulvérisation cathodique, et qui résolve les problèmes des procédés de l'art antérieur.

Ce but, et d'autres encore, sont atteints, conformément à l'invention par un procédé de préparation d'un revêtement optique sur un substrat par dépôt d'au moins une couche par évaporation sous vide d'une poudre placée dans un creuset, dans lequel ladite poudre est constituée d'un mélange de poudre de silicium et de poudre de silice.

Selon l'invention, il a été constaté, de manière totalement surprenante, qu'il était possible de réaliser l'évaporation d'un mélange de poudre de silice et de poudre de silicium, sans que ne se produise aucune réaction, ni aucun amalgame des constituants de la poudre et, notamment, de la silice avec le matériau réfractaire de la nacelle ou creuset, à savoir généralement le tantale ou le molybdène. Il est étonnant que l'évaporation d'un mélange de poudre de silicium et de poudre de silice ne produise aucun effet indésirable sur le matériau de la nacelle et se déroule sans attaque chimique, sans amalgame, alors même que l'évaporation de poudre de silicium pur est accompagnée d'une réaction violente avec le matériau du creuset, conduisant le plus souvent à la détérioration irrémédiable de celui-ci et à son perçage, rendant ainsi en définitive le dépôt impossible. En outre, du fait de l'absence de réaction entre le matériau à évaporer et celui constituant la nacelle, les composés évaporés et donc les dépôts formés sont d'une grande pureté, et leurs propriétés physiques excellentes et parfaitement maîtrisées. Sans vouloir être lié par aucune théorie, il semblerait que dans le mélange de poudre de Si et de poudre de SiO₂, selon l'invention, les grains de SiO₂ soient entourés par des grains de Si, ce qui éviterait leur réaction avec le creuset, au contraire du SiO₂ pur.

Le procédé selon l'invention rend possible l'utilisation d'un procédé d'évaporation, simple et peu coûteux, à mettre en oeuvre pour la préparation des couches optiques à base d'oxydes de silicium, sans qu'il soit nécessaire de faire appel à des poudres de départ peu disponibles et extrêmement onéreuses, comme le SiO. L'invention va à l'encontre d'un préjugé largement répandu dans le domaine de la technique, selon lequel il aurait été impossible d'évaporer de la silice pour préparer des couches optiques, en mettant en oeuvre, de manière étonnante, un mélange de poudre de Si et de SiO₂. L'invention surmonte ce préjugé et évite l'utilisation de poudre de SiO, avec les inconvénients qui lui sont liée.

En effet, l'évaporation de la poudre Si et de SiO₂ conduit, de nouveau, de manière surprenante, au dépôt d'une couche de SiO et non d'une couche de Si ou de SiO₂, comme on aurait pu s'y attendre. En outre, le procédé selon l'invention présente tous les avantages inhérents au procédé d'évaporation en nacelle ou en creuset, par rapport aux procédés physiques de l'art antérieur, tels qu'évaporation au canon à électrons, pulvérisation cathodique, couramment utilisés pour le dépôt de couches analogues à partir de SiO₂ : à savoir, entre autres, simplicité des appareils, pas d'utilisation de haute tension, faible consommation d'énergie, machine pouvant être manipulée par un personnel peu ou pas qualifié, produits de départ largement disponibles dans le commerce et d'un prix faible, etc.

Enfin, les couches déposées par le procédé de l'invention présentent une pureté supérieure et d'excellentes caractéristiques optiques, de résistance mécanique, d'homogénéité, etc., et leur épaisseur peut être très facilement contrôlée, mesurée, par exemple à l'aide d'une balance à quartz d'une très grande précision.

Le pourcentage de chacune des poudres de SiO₂ et de Si, dans le mélange des poudres, n'est pas fondamental et l'effet inattendu de l'invention peut être obtenu pour des pourcentages très faibles de Si. De préférence, le mélange sera constitué en poids de 15 à 50 %, de préférence encore de 25 à 45 % de poudre Si et de 50 à 85 %, de préférence encore de 55 à 75 % de poudre SiO₂. Un mélange typique sera constitué de 40 % de poudre Si et de 60 % de poudre SiO₂.

De préférence, la granulométrie de chacune des deux poudres mises en oeuvre est du même ordre, par exemple cette granulométrie moyenne sera de 5 microns à 3/10 de mm ; par exemple de 50 microns.

Quelles que soient les proportions du mélange, on obtient, dans ce cas, le dépôt d'une couche de SiO, sans faire appel à de la poudre de SiO, onéreuse et rare, dans le creuset.

La couche préparée de SiO, ainsi préparée, est une couche déposée par évaporation non réactive, et est une couche qui ne contribue généralement que de manière secondaire aux propriétés optiques de l'ensemble du revêtement. Elle constituera généralement une couche, dite « couche d'accroche » appliquée directement sur le substrat ou sur le substrat pourvu de vernis. Cette couche d'accroche en SiO a une épaisseur généralement de 100 à 200 Å.

Selon l'invention, le dépôt de ladite couche par évaporation sous vide peut aussi être effectué par évaporation réactive, c'est-à-dire que l'évaporation est réalisée en présence d'un gaz oxygéné, qui est introduit dans la chambre à vide. Ce gaz peut être de l'oxygène pur, et plus généralement un gaz « riche » en oxygène.

Dans ce cas, la couche de SiO, déposée comme précédemment, à partir du mélange de poudre de Si et de poudre de SiO₂, est transformée en oxyde de silicium à teneur plus élevée en oxygène, du fait de la présence d'oxygène dans la chambre à vide.

L'oxydation de la couche de SiO va donc conduire à une couche constituée, de manière générale, de SiₓO_{y}, ou x est un nombre réel de 1 à 3 et y et un nombre réel de 1 à 5. Il pourra s'agir, par exemple, de SiO, de Si₂O₃, de Si₃O₅, de Si₅O₁₂, et jusqu'à SiO₂, suivant la quantité d'oxygène, le débit dans l'enceinte sous vide et d'autres paramètres influençant le dépôt. La couche de SiO ou la couche de SiₓO_{y}, déposée par le procédé d'évaporation, éventuellement réactive selon l'invention, peut être toute couche possédant des propriétés optiques et elle couvre toute la gamme des indices de réfraction. Elle peut être ainsi une couche à indice de réfraction élevée, c'est-à-dire généralement d'environ 1,8 à 2,2 ; une couche à indice de réfraction moyen, c'est-à-dire généralement d'environ 1,60 à 1,70 ; ou encore à faible indice de réfraction, c'est-à-dire généralement d'environ 1,42 à 1,50. A ces différentes valeurs d'indice de réfraction, correspondent simplement des valeurs différentes de x et y. De manière générale, l'indice de réfraction est d'autant plus élevé que le rapport x/y est grand. Ainsi, par exemple, les couches ou sous-couches de SiO₂ (sous-couche constituant, par exemple, une couche à indice moyen) seront des couches ou sous-couches à faible indice de réfraction, tandis que les couches ou sous-couches de SiO seront des couches ou sous-couches à indice de réfraction élevée ; il est à noter que ces couches ou sous-couches de SiO, qui sont des couches à propriétés optiques, ne diffèrent de la couche de SiO, dite « couche d'accroche », que par leur épaisseur sensiblement plus élevée, pouvant atteindre un quart de largeur d'onde. Précisons que dans cette description, on entend, par les termes « au moins une des couches dudit revêtement » que au moins une des couches déposées est déposée par évaporation du mélange de poudre spécifique selon l'invention, que cette évaporation soit réactive ou non réactive, le revêtement déposé peut, bien sûr, aussi comprendre plusieurs couches déposées par évaporation du mélange de poudre selon l'invention, que cette évaporation soit réactive ou non réactive.

Le procédé selon l'invention de préparation d'un revêtement optique sur un substrat peut donc comprendre, au moins une étape choisie parmi les étapes suivantes :
- dépôt d'une couche à faible indice de réfraction ;
- dépôt d'une couche à indice de réfraction moyen ou médian ;
- dépôt d'une couche à indice de réfraction élevé ;
- éventuellement dépôt d'une couche hydrophobe ;
- éventuellement, dépôt sur le substrat d'une couche d'accroche, le dépôt d'au moins une des couches parmi la couche à faible indice de réfraction, la couche à indice de réfraction moyen, la couche à indice de réfraction élevée, et, éventuellement, la couche d'accroche étant effectué par évaporation sous vide, éventuellement réactive, d'une poudre selon l'invention.

L'invention concerne, en outre, un procédé de préparation de deux types particuliers de revêtements optiques : à savoir, un revêtement antireflets à bande étroite ou un matériau antireflet à bande large.

Le procédé de préparation d'un revêtement optique, qui est un revêtement antireflets à bande étroite, est un procédé dans lequel on effectue les étapes successives suivantes :
- dépôt sur le substrat d'une couche dite « couche d'accroche » ;
- dépôt d'une couche à indice de réfraction élevé ;
- dépôt d'une couche à faible indice de réfraction ;
- éventuellement dépôt d'une couche hydrophobe ;

Le revêtement optique obtenu par ce procédé, sera plutôt un revêtement antireflet à « bande étroite », mais extrêmement performant et convenant plus particulièrement à des applications en lunetterie.

Le procédé de préparation d'un matériau optique, qui est un revêtement antireflets à large bande, comprend, en outre, l'application sur la « couche d'accroche » et au-dessous de la couche à indice de réfraction élevé, d'une couche à indice de réfraction moyen ou médian, dite couche du bas.

La couche à indice de réfraction moyen peut être formée par superposition de deux sous-couches, c'est-à-dire en déposant successivement une première sous-couche à indice de réfraction élevé, puis une seconde sous-couche à faible indice de réfraction.

Dans ce qui précède, la couche et/ou la sous-couche à faible indice de réfraction, la couche à indice de réfraction moyen, la couche et/ou la sous-couche à indice de réfraction élevé et, éventuellement la couche d'accroche peuvent être déposées, outre par le procédé de l'invention, par tout procédé connu, par exemple, il pourra s'agir de couches ou sous-couches colloïdales ou polymères. En particulier, il s'agit de couches, par exemple, de silice polymérique ou de silice colloïdale pour les couches à faible indice de réfraction, qui sont déposées, par exemple, par enduction centrifuge ou centrifugation (« spin coating »), éventuellement suivie d'une densification réticulation par chauffage ou irradiation, de tels procédés sont décrits, par exemple dans les documents FR-A-2 759 360 et FR-A-2 759 464, incorporées ici à titre de référence, en ce qui concerne les parties pertinentes relatives au dépôt de telles couches. Il est à noter que de telles couches à faible indice de réfraction, colloïdales ou polymères, peuvent, lorsqu'elles constituent la couche supérieure du revêtement, posséder, intrinsèquement, des propriétés hydrophobes - c'est-à-dire que ces propriétés sont incorporées dans leur formule - le procédé ne comprend alors pas, avantageusement, d'étape de dépôt de couche hydrophobe.

La condition à respecter pour tous les revêtements optiques préparés est qu'au moins une des couches du revêtement soit déposée par évaporation éventuellement réactive du mélange de poudre, selon l'invention.

Cependant, dans ce qui précède, la couche, dite « couche d'accroche », déposée sur le substrat, est, de préférence, une couche en SiO déposée par le procédé selon l'invention, décrit plus haut, c'est-à-dire par évaporation sous vide, non réactive, d'un mélange de poudre de silicium et de poudre de silice.

La couche à faible indice de réfraction est, de préférence, une couche de SiₓO_{y}, en particulier de SiO₂, déposée par le procédé selon l'invention, c'est-à-dire par évaporation sous vide réactive d'un mélange de poudre de silicium et de poudre de silice, en présence d'oxygène.

Le dépôt de la couche à indice de réfraction élevé est, de préférence, effectué par évaporation sous vide d'un oxyde de métal ou de métalloïde choisi, de préférence, parmi les oxydes de titane, tantale, zirconium, cérium, l'oxyde préféré étant l'oxyde de titane Ti₂O₃, TiO₂ ou TiO. Cette évaporation peut être une évaporation réactive dans des conditions analogues à celles mentionnées plus haut. De préférence encore, le dépôt de la couche à indice de réfraction élevé est également effectué par le procédé selon l'invention, c'est-à-dire par évaporation sous vide, non réactive d'un mélange de poudre de silicium et de poudre de SiO₂.

Le dépôt de la première sous-couche, à indice de réfraction élevé de la couche à indice de réfraction moyen est effectué, de préférence, par évaporation sous vide d'un oxyde de métal ou de métalloïde choisi, de préférence, parmi les oxydes de titane, de tantale, de zirconium, de cérium, l'oxyde préféré étant l'oxyde de titane Ti₂O₃.

Le dépôt de la seconde sous-couche à faible indice de réfraction de la couche à indice de réfraction moyen est, qui est de préférence, une sous-couche de SiₓO_{y}, en particulier de SiO₂, est de préférence effectué par le procédé selon l'invention, d'évaporation réactive sous vide d'un mélange de poudres de Si et de SiO₂, en présence d'oxygène.

Le dépôt de la couche à indice de réfraction moyen, qui est une couche de SiₓO_{y}, peut également être effectué entièrement par le procédé de l'invention d'évaporation réactive sous vide d'un mélange de poudre de Si et de SiO₂ en présence d'oxygène.

De préférence encore, selon l'invention, le dépôt de toutes les couches formant le revêtement optique, à l'exception, bien entendu, de la couche hydrophobe éventuelle, est effectué par le procédé selon l'invention, c'est-à-dire par évaporation réactive ou non réactive d'un mélange de poudre de silicium et de poudre de silice.

Il est à noter que, dans le cas d'une application sur un substrat ou support organique (« verre organique-plastique »), il faut veiller à utiliser, soit une matière peu déformable, c'est-à-dire à faible coefficient de dilatation thermique, soit un support plastique, préalablement revêtu d'un vernis. Le procédé selon l'invention peut donc éventuellement comprendre, en outre, une étape préalable d'application, de dépôt d'un vernis sur le substrat « nu » non revêtu. Le vernis est choisi généralement parmi les vernis siliciés, permettant le pontage, les vernis de type organosilane, en particulier polysiloxane, et les vernis de type grains de silice enrobés dans un polymère, dits vernis « nanocomposites », la taille des grains étant inférieure à l'épaisseur de diffraction qui est généralement de 12 nm.

Le procédé selon l'invention comprend, en outre, de préférence, une étape finale de dépôt d'une couche supérieure hydrophobe, cette couche est déposée sur la dernière couche précédemment déposée qui est généralement une couche à faible indice de réfraction.

En effet, bien que la résistance aux attaques chimiques et mécaniques du revêtement, tel qu'un revêtement antireflets préparé par le procédé de l'invention, soit déjà excellente, afin de renforcer les propriétés chimiques et mécaniques de l'empilement, par exemple, antireflet, on dépose, de préférence, dans le procédé de l'invention, dans une étape finale, un film mince hydrophobe à faible coefficient de friction, pour protéger la dernière couche, telle qu'une couche à faible indice de réfraction.

Cet agent hydrophobe peut être choisi parmi les poly(tétrafluoroéthylène), tels que les Teflon® , mais les composés de type silane fluoré seront préférés.

Les composés silanes fluorés présentent l'avantage de former une liaison chimique car ils contiennent des groupements susceptibles de réagir avec les groupements hydroxyles situés à la surface du revêtement, et une chaîne fluorée longue assurant le caractère hydrophobe et le faible coefficient de friction du dépôt.

Parmi les produits existants, on a choisi le C₆F₁₃CH₂CH₂-Si (Oet)₃((Tridécafluoro-1,2,2,2-tétrahydrooctyl)-1-triéthoxysilane), connu sous le nom de T2494 de chez ABCR ou le C₆F₁₃CH₂CH₂-SiCl₃((tridécafluoro-1, 2, 2, 2-tétrahydro-octyl)-1-trichlorosilane, connu sous le nom de T2492 de chez ABCR.

Ces dérivés ont un faible indice de réfraction, à savoir environ 1,4 et sont solubles dans certains composés perfluorés.

Le système obtenu, formé par le « T2494 » et la dernière couche déposée, par exemple, à faible indice de réfraction, telle que la silice déposée par évaporation réactive selon le procédé de l'invention, ou bien de la silice polymérique, est inerte aux acides forts et bases fortes et aux solvants organiques usuels. La couche est parfaitement hydrophobe et très peu mouillable à l'éthanol. Elle peut être très facilement nettoyée.

Du fait de sa très faible épaisseur (par exemple quelques Angströms, c'est-à-dire une dizaine d'Angströms), la couche hydrophobe ne perturbe pas les propriétés optiques de la couche à faible indice, par exemple de la couche de silice ou de silice polymérique.

Le dépôt de la couche hydrophobe de silane fluoré, tel que le « T2494 » est effectué, de préférence, par pulvérisation, sur la dernière couche déposée, telle qu'une couche faible indice. L'agent hydrophobe est généralement dilué dans un solvant, tel qu'un solvant perfluoré, à raison, par exemple de 2 % en masse et il est appliqué généralement à chaud à une température voisine, par exemple, de 100°C.

Il peut aussi être appliqué par la voie sol-gel.

Avantageusement, selon l'invention, le dépôt d'au moins une couche, de préférence, de chaque couche, est précédé d'un traitement d'activation par plasma, de préférence, par plasma à l'argon. Généralement, le plasma est un plasma haute tension, c'est-à-dire, de préférence, de 500 à 3 000 Volts et à basse fréquence, c'est-à-dire de 20 kHz à 100 kHz.

Il a été mis en évidence que ce traitement d'activation au plasma, favorisait grandement l'accroche, l'adhérence, sur le substrat et sur la couche précédente déposée.

Un procédé encore préféré, selon l'invention, est un procédé de dépôt d'un revêtement antireflets large bande sur un substrat organique, qui comprend les étapes successives suivantes :
- dépôt d'une couche de vernis, tel qu'un vernis polysiloxane, sur le substrat organique ;
- dépôt d'une première couche, dite couche « d'accroche », en SiO, par évaporation sous vide d'un mélange de poudre de silicium et de poudre de silice ;
- dépôt d'une deuxième couche à indice de réfraction moyen, par dépôts successifs d'une première sous-couche à indice de réfraction élevé, par évaporation réactive d'un oxyde de métal ou de métalloïde, tel qu'un oxyde de titane, par exemple, Ti₂O₃, TiO, ou TiO₂, puis d'une seconde sous-couche de SiₓO_{y} à faible indice de réfraction, par évaporation réactive sous vide d'un mélange de poudre de silicium et de poudre de silice ; ou par évaporation sous vide réactive d'un mélange de poudre de silicium et de poudre de silice ; l'épaisseur cumulée de la première couche et la deuxième couche correspondant à une épaisseur de ¼ de longueur d'onde ;
- dépôt d'une troisième couche à indice de réfraction élevé par évaporation réactive sous vide d'un oxyde de métal ou de métalloïde, tel qu'un oxyde de titane ; ou par évaporation sous vide, éventuellement réactive, d'un mélange de poudre de Si et de poudre de silice ; l'épaisseur de la troisième couche correspondant à une demi longueur d'onde.
- dépôt d'une quatrième couche de SiₓO_{y} à faible indice de réfraction par évaporation réactive d'un mélange de poudre de silicium et de poudre de silice, l'épaisseur de la quatrième couche correspondant à un quart de longueur d'onde ;
- éventuellement, dépôt d'une couche antiabrasive et/ou hydrophobe, par exemple de silane fluoré.

On note donc, que dans ce procédé, le dépôt de l'ensemble des couches et, éventuellement, sous-couches du revêtement complexe antireflets est effectué avec seulement deux produits de départ et donc deux nacelles, à savoir, par exemple un oxyde de titane, tel que le Ti₂O₃ et le mélange de poudre de Si et de SiO₂ selon l'invention, et que à partir de ces deux produits de départ, on obtient trois types de couches et sous-couches différentes : SiO, SiₓO_{y} et, par exemple Ti₂O₃. Le dépôt peut même être effectué avec un seul produit de départ et donc une seule nacelle contenant le mélange de poudre selon l'invention, en agissant simplement sur la présence ou non d'oxygène et la proportion de celui-ci.

En variante, comme on l'a indiqué plus haut, la dernière couche à faible indice de réfraction peut être déposée, par exemple, par centrifugation d'une couche de précurseur de silice polymérique qui est ensuite polymérisée par chauffage ou par irradiation aux UV ou par centrifugation de silice colloïdale. Si cette couche possède, en outre, des propriétés hydrophobes dans sa formule, alors on peut se passer du dépôt de la dernière couche hydrophobe.

L'invention sera mieux comprise à la lecture de la description détaillée qui va suivre, donnée à titre illustratif et non limitatif, faite en référence aux dessins joints, dans lesquels :
- la figure 1 est une vue en coupe schématique d'une installation pour la mise en oeuvre du procédé de l'invention ;
- la figure 2 est un graphique qui représente la valeur de la réflectance R en %, en fonction de la longueur d'onde (λ) en nm, pour un revêtement antireflets selon l'invention (Exemple).

De manière plus précise, préalablement au dépôt, des revêtements par évaporation selon l'invention, on peut procéder à un certain nombre d'étapes de préparation, de lavage, de séchage des substrats à revêtir.

Le substrat peut être un substrat organique ou inorganique, toutefois, l'invention s'applique avantageusement au traitement des substrats organiques.

Dans la suite de la description, le terme « substrat organique » désigne plus précisément un substrat plastique, par exemple l'un de ceux choisis parmi les polyacrylates, les polycarbonates, le polyallylcarbonates et les polyamides. Toutefois, cette liste n'est pas limitative et couvre de façon plus générale les matériaux polymères organiques.

Le terme « substrat inorganique » couvre plus précisément un substrat minéral, c'est-à-dire par exemple les matériaux amorphes ou même cristallins et notamment la silice, les verres borosilicatés ou sodocalciques, les fluorophosphates et les phosphates.

Comparés aux substrats minéraux, les substrats plastiques sont avant tout moins coûteux, plus facilement modulables, plus légers et moins fragiles aux chocs. Cependant, leur utilisation nécessite préférentiellement, la présence d'une couche intercalée entre le substrat organique et la première couche déposée, assurant une bonne compatibilité à cette interface et en particulier une absorption des contraintes induites. Selon l'invention, on choisit cette couche d'interface, ou vernis, de préférence parmi les polymères organosilanes, chargés éventuellement en colloïdes minéraux, par exemple en silice (voir plus haut).

Généralement le substrat est un substrat plan ou un substrat présentant une faible courbure, par exemple, la surface d'un écran à tube cathodique pour téléviseur, un verre de lunettes ou une lentille, mais le procédé selon l'invention permet de revêtir tout substrat quelle que soit sa forme.

Les substrats, tels que les lentilles, de préférence revêtues de vernis, sont placés avantageusement pour tout le reste du traitement sur des moyens supports classiques adéquats.

On procède ensuite, de préférence, à une étape de lavage des lentilles, toujours sur leur pince. Dans ce but, les pinces sont généralement introduites dans un système de cuves de lavage à ultrasons selon le procédé normalisé, couramment utilisé dans ce domaine de la technique.

Puis, on procède à l'étuvage des substrats, tels que des lentilles, en les plaçant dans une étuve, afin de parfaire leur séchage à une température généralement de 70 à 80°C, pendant le temps nécessaire, qui peut aller, par exemple, de 1 à 4 heures. Puis, les substrats, tels que les lentilles, sont envoyés dans l'installation, permettant la mise en oeuvre du procédé selon l'invention, ou plus précisément de l'étape essentielle d'évaporation du procédé selon l'invention. Cette installation comprend essentiellement une enceinte sous vide 1 placée sur un bâti 2, enceinte dans laquelle est réalisée le dépôt de couches par évaporation sous vide, selon l'invention.

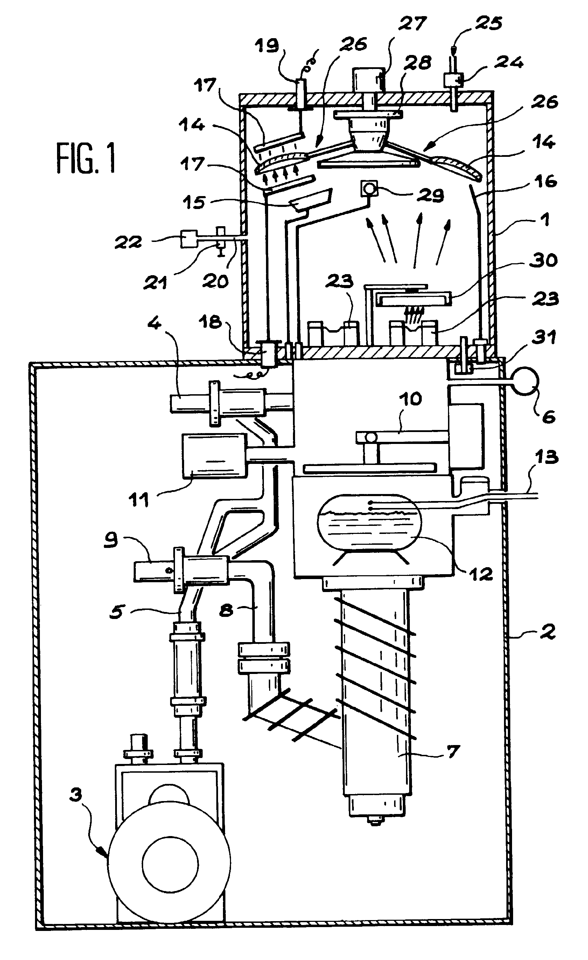

Cette installation comprend des moyens pour mettre ladite enceinte sous vide ; sur la figure 1, ces moyens comprennent en premier lieu des moyens pour établir un vide primaire dans l'enceinte, ces moyens comprennent, une pompe mécanique à double étage 3, qui permet de réaliser un premier vidage de l'enceinte 1, par l'intermédiaire de la vanne 4 et de la canalisation 5.

Les moyens de mise sous vide comprennent aussi des moyens de mesure du vide, par exemple une jauge de mesure du vide primaire, généralement de type thermocouple 6, qui permet de suivre la descente en vide, jusqu'à une première valeur de la pression d'environ 10⁻² Torr.

Cette jauge de mesure, de type thermocouple 6, peut être remplacée sans problème par une jauge de type « PIRANI », c'est-à-dire par mesure résistive d'un filament chauffé. Une fois que la première valeur de la pression est atteinte, la vanne 4 est fermée.

Les moyens pour mettre l'enceinte sous vide comprennent, en outre, des moyens pour réaliser un vide poussé ou vide secondaire dans l'enceinte, qui sont mis en oeuvre une fois que le vide primaire, défini ci-dessus, a été atteint.

Ces moyens pour réaliser un vide poussé ou vide secondaire comprennent essentiellement, par exemple, une pompe à diffusion 7 ou une pompe turbomoléculaire, reliée à l'enceinte 1, par l'intermédiaire d'une canalisation 8, pourvue d'une vanne 9. Cette vanne 9 est ouverte et la pompe à diffusion 7 activée, lorsque le vide primaire a été atteint et que la vanne 4 a été fermée.

Les moyens pour réaliser un vide poussé comprennent aussi une vanne d'isolement de haut vide 10. Au bout d'une certaine durée, généralement de quelques secondes après le début du fonctionnement de la pompe de diffusion, cette vanne d'isolement de haut vide 10 est ouverte, ce qui permet à la pompe de diffusion 7 de parfaire le vide dans l'enceinte et d'atteindre la pression finale qui est celle du procédé selon l'invention.

La descente en vide se fait régulièrement, de façon à obtenir le vide voulu, généralement dans la plage de 10⁻⁵ à 10⁻⁶ Torr. Afin de mesurer la pression, sont également prévus des moyens de mesure de la pression du vide secondaire final, généralement constitués par une jauge de type « Penning » 11, c'est-à-dire à cathode froide.

L'installation comprend également des moyens pour capter les molécules d'eau se trouvant dans l'atmosphère de l'enceinte. De préférence, il s'agit d'un « baffle » ou piège à azote liquide 12, ce baffle 12, rempli d'azote liquide, permet efficacement, par la basse température qu'il transmet, de piéger les molécules d'eau en garantissant la descente en vide, le gaz issu de l'enceinte étant ensuite évacué par la canalisation 13.

Ce système d'ampoule d'azote liquide est simple à utiliser, d'un coût de revient modique et d'un approvisionnement facile par bonbonne de petite quantité.

Il est naturellement possible d'effectuer une cryogénie du même type, en utilisant tout autre système cryogénique différent, par exemple de type « MESSNER », ou encore un système cryogénique à l'hélium.

L'installation comprend ensuite des moyens d'étuvage et de mise en température des substrats à revêtir, tels que des lentilles 14.

Ces moyens sont constitués, par exemple, par un système à lampe à halogène 15 ; des moyens de mesure et de régulation de la températures, tels qu'un thermocouple, 16, agissant sur un régulateur électronique (non représenté), assurent la montée progressive des substrats, tels que des lentilles, à la température optimisée, nécessaire au traitement considéré.

De préférence, l'installation comprend des moyens pour réaliser une activation ou préparation par un plasma des substrats à revêtir, tels que des lentilles.

Ces moyens comprennent, d'une part, des moyens pour générer le plasma et, d'autre part, des moyens pour générer une atmosphère gazeuse, de préférence une atmosphère d'argon à l'intérieur de l'enceinte. Les moyens pour générer le plasma sont généralement constitués par des électrodes parallèles flottantes 17 qui sont raccordées à une alimentation haute tension et basse fréquence, par l'intermédiaire de « passages à vides » 18 et 19, étanches et isolés électriquement. Par haute tension et basse fréquence, on entend généralement une tension de 500 à 3 000 volts, et une fréquence de 20 kHz à 100 kHz.

Les moyens pour créer une atmosphère gazeuse, par exemple une atmosphère d'argon, à une pression définie, de préférence de 200 Millitorrs, comprennent une canalisation 20 et une vanne micrométrique d'ajustage de débit 21, dont l'isolement est assuré par une vanne électromagnétique « tout ou rien » 22, située en amont de celle-ci (21), sur la canalisation 20.

Le plasma provoque une ionisation du gaz et permet d'effectuer un bombardement ionique et électronique des substrats, tels que des lentilles, simultanément sur les deux faces, ce traitement est possible aussi bien sur le substrat nu, que sur une couche déjà appliquée. Il favorise grandement l'accroche sur le substrat, et/ou sur la couche précédemment appliquée.

La durée de l'action du plasma est adaptée suivant le type de substrat, par exemple de lentille et de procédé à réaliser, la nature des couches déposées, etc..

Les moyens pour réaliser l'évaporation comprennent des sources d'évaporation traditionnelles 23. Sur la figure 1, on a représenté deux de ces sources 23, mais leur nombre peut être quelconque, par exemple un, trois, quatre ou cinq, en fonction des nécessités du procédé. Les sources sont alimentées en basse tension, à l'aide de transformateurs moyenne tension au primaire (non représentés).

La puissance nécessaire à la montée en température des nacelles 23, qui sont généralement en molybdène, tantale ou tungstène, est réalisée par un boîtier thyristor (non représenté), qui assure l'alimentation du primaire des transformateurs en tension variable.

La température des nacelles est maintenue, lors du procédé, généralement de 1 000 à 2 300°C, selon les matériaux à évaporer ou sublimer.

Dans le cas où l'on procède à une évaporation réactive, c'est-à-dire en présence d'un gaz oxygéné, des moyens sont prévus pour créer une atmosphère oxygénée, à l'intérieur de l'enceinte 1, par exemple à une pression de 2.10⁻⁴ à 4.10⁻⁵ Torr.

Ces moyens comprennent, par exemple, une vanne piézo-électrique 24, sur une canalisation alimentée en oxygène 25, qui permet, par exemple, une entrée d'oxygène dans l'enceinte pour l'évaporation réactive nécessaire à certains dépôts.

La gestion du débit d'entrée d'oxygène est réalisée à l'aide d'un ensemble électronique dont la fonction est d'assurer une ouverture proportionnelle de cette microvanne selon le débit et la pression désirés.

L'installation comprend aussi des moyens de maintien, de manipulation, de déplacement, ou de transport du ou des substrat(s) à traiter par le procédé selon l'invention.

Les moyens de maintien des substrats, tels que des lentilles, à traiter, sont généralement constitués essentiellement par un support ou dôme porte verre classique (26).

Dans l'enceinte sous vide de la figure 1, les supports (26) sont fixés à des moyens de mise en rotation.

Les moyens de déplacement des substrats, tels que des lentilles, à l'intérieur de l'enceinte, comprennent des moyens de mise en rotation constitués, notamment, d'un motoréducteur 27 ; la rotation des substrats permet une répartition régulière des dépôts.

Les moyens de déplacement comprennent également, de préférence, des moyens de retournement des substrats, tels que des lentilles. En effet, les lentilles doivent être traitées sur les deux faces pour une complète efficacité. Les moyens de retournement mécanique comprennent, sur la figure 1, un système de retournement mécanique 28, réalisé grâce à un pignon principal, qui actionne les pignons satellites.

Une commande de rotation de ce pignon principal par alimentation électrique basse tension variable, d'une part, et inversion du sens de celle-ci, d'autre part, permet avec une extrême douceur d'assurer le retournement des verres tenus dans leur support.

Ainsi, le procédé pourra, si on le désire, consister en des dépôts successifs et alternés sur chaque face de chaque couche, d'un revêtement multicouche, ou bien dépôt des couches multiples, c'est-à-dire de l'ensemble du revêtement multicouches, sur la première face, retournement et dépôts successifs, de la même manière, des couches multiples, formant l'ensemble du revêtement, sur la deuxième face.

La première variante permet de réaliser la globalité du traitement des deux faces d'une manière plus rapide, étant donné que cette option permet de garder la source d'évaporation « chaude » pour pouvoir, de ce fait, procéder immédiatement au dépôt sur la seconde face.

Des moyens de contrôle de l'épaisseur de la ou de chaque couche sont avantageusement prévus dans l'installation.

Il s'agit généralement d'un système de mesure 29 utilisant la variation de la fréquence d'un cristal de quartz.

Cet appareillage, appelé « balance à quartz », permet le suivi, avec une extrême précision, de l'évolution en épaisseur du dépôt de chaque couche pendant celui-ci.

Lorsque la valeur souhaitée est obtenue, l'action d'un volet pneumatique 30 arrête instantanément le dépôt à la valeur de l'épaisseur requise.

Par ailleurs, les paramètres physiques spécifiques de chaque couche sont saisis dans les fichiers informatiques de l'appareillage.

L'installation comporte enfin des moyens de mise à l'atmosphère, en fin de procédé. Il s'agit, sur la figure 1, de la vanne 31.

De préférence, des moyens de régulation et de contrôle sont prévus pour assurer le fonctionnement automatique de l'installation. Il s'agit généralement d'un système informatisé, qui permet, d'une manière harmonisée, la gestion de toutes les étapes du procédé sans avoir recours à un opérateur.

L'invention va maintenant être décrite en référence à l'exemple suivant, donné à titre illustratif et non limitatif.

### Exemple

Cet exemple illustre la préparation sur un revêtement antireflets à large bande sur un substrat en polyalkylcarbonate, constitué par des lentilles de 70 mm de diamètre.

Le dispositif utilisé pour préparer ce revêtement est sensiblement celui décrit ci-dessus et sur la figure 1 avec deux creusets.

### a. Préparation du mélange de poudres pour l'évaporation sous vide

On réalise, tout d'abord, un mélange de poudre de silicium et de silice. La granulométrie de ces deux poudres est du même ordre, à savoir 5 microns. Les proportions en poids de chacune des poudres dans le mélange sont respectivement de 30 % de poudre de silicium et de 70 % de poudre de silice. Le mélange de poudre est préparé dans un appareil mélangeur.

### b. Préparatifs pour l'évaporation

### b. 1. Remplissage du creuset n° 1

On remplit du mélange préparé ci-dessus, le creuset n° 1, qui est réalisé en molybdène.

On recouvre ce creuset d'un couvercle percé de trou permettant de réaliser une chicane ; ainsi, la projection de particules du mélange est évitée pendant la montée en puissance du creuset.

### c. Remplissage du creuset n° 2

On remplit de granulés d'oxyde de titane Ti₂O₃ le creuset n° 2, lui-même réalisé en tantale ou tungstène.

### d. Dépôts

Après réalisation d'un vide de l'ordre de 4.10⁻⁶ torr, on réalise les dépôts successifs suivants :
- Première couche déposée à partir du mélange silicium/silice et d'une épaisseur métrique de 150 Å.
- Seconde couche d'oxyde de titane déposée sous évaporation réactive d'oxygène à une pression de 4 x 10⁻⁵ torr et d'une épaisseur métrique de 52 Å.
- Troisième couche déposée à partir du mélange silicium/silice sous évaporation réactive d'oxygène à une pression de 4 x 10⁻⁵ torr et d'une épaisseur métrique de 245 Å.
   Ces trois premières couches représentent le premier ¼ de longueur d'onde et définissent en fait la « première couche » du revêtement antireflets.
- Quatrième couche d'oxyde de titane déposée sous évaporation réactive d'oxygène à une pression de 4 x 10⁻⁵ torr et d'une épaisseur métrique de 780 Å.
   Cette quatrième couche représente la couche d'épaisseur ½ de longueur d'onde et d'indice de réfraction élevé.
- Cinquième couche déposée à partir du mélange silicium/silice sous évaporation réactive d'oxygène à une pression de 4 x 10⁻⁵ torr et d'une épaisseur métrique de 840 Å.

Cette cinquième couche représente le dernier ¼ de longueur d'onde.

Les valeurs d'épaisseur sont données à titre indicatif et sont variables selon la géométrie et la distance entre substrat et source d'évaporation.

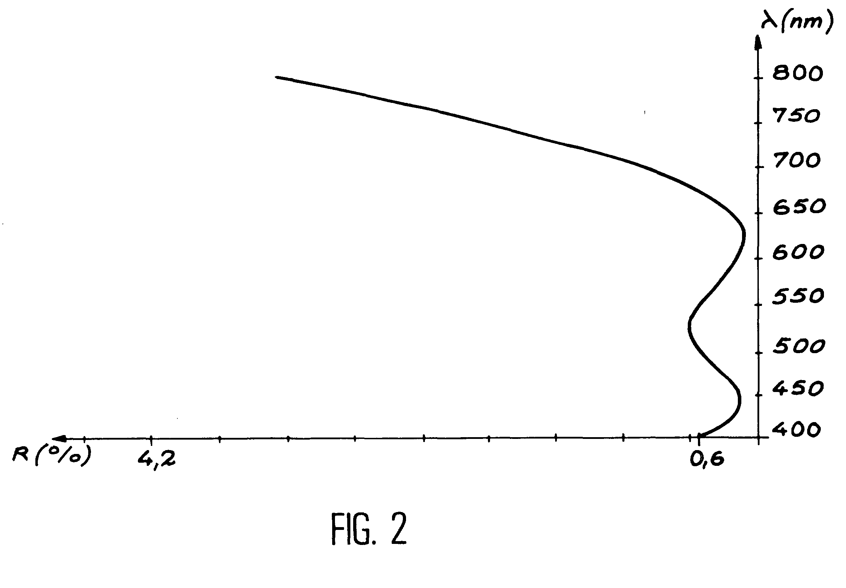

Les caractéristiques optiques du revêtement antireflets, ainsi déposé, sont données sur la figure 2, qui représente sa courbe d'efficacité antireflet large bande (mesures en réflexion d'une face traitée effectuées par rapport à un témoin).

## Revendications

1. Procédé de préparation d'un revêtement optique sur un substrat, dans lequel on dépose au moins une des couches dudit revêtement par évaporation sous vide d'une poudre, ladite poudre étant constituée d'un mélange de poudre de silicium et de poudre de silice.

2. Procédé selon la revendication 1, dans lequel ladite poudre est constituée en poids de 15 à 50 % de poudre de silicium, et de 50 à 85 % de poudre de silice.

3. Procédé selon l'une quelconque des revendications 1 et 2, dans lequel la granulométrie de la poudre de silicium et la granulométrie de la poudre de silice sont du même ordre.

4. Procédé selon l'une quelconque des revendications 1 à 3, dans lequel ladite évaporation est une évaporation réactive, réalisée en présence d'un gaz oxygéné.

5. Procédé selon la revendication 4, dans lequel ledit gaz est choisi parmi l'oxygène pur et les gaz riches en oxygène.

6. Procédé selon l'une quelconque des revendications 1 à 5, comprenant au moins une étape choisie parmi les étapes suivantes :
- dépôt d'une couche à faible indice de réfraction ;
- dépôt d'une couche à indice de réfraction moyen ;
- dépôt d'une couche à indice de réfraction élevé ;
- éventuellement, dépôt d'une couche hydrophobe ;
- éventuellement, dépôt sur le substrat d'une couche d'accroche, dans lequel le dépôt d'au moins une des couches parmi la couche à faible indice de réfraction, la couche à indice de réfraction moyen, la couche à indice de réfraction élevé, et, éventuellement, la couche d'accroche, étant effectué par évaporation sous vide, éventuellement réactive selon l'une quelconque des revendications 1 à 5.

7. Procédé de préparation d'un revêtement selon la revendication 6, qui est un revêtement antireflets à bande étroite, dans lequel on effectue les étapes successives suivantes :
- dépôt sur le substrat d'une couche, dite « couche d'accroche » ;
- dépôt d'une couche à indice de réfraction élevé ;
- dépôt d'une couche à faible indice de réfraction ;
- éventuellement, dépôt d'une couche hydrophobe.

8. Procédé de préparation d'un revêtement selon la revendication 6, qui est un revêtement antireflets à large bande, dans lequel on effectue les étapes successives suivantes :
- dépôt sur le substrat d'une couche, dite « couche d'accroche » ;
- dépôt d'une couche à indice de réfraction moyen ;
- dépôt d'une couche à indice de réfraction élevé ;
- dépôt d'une couche à faible indice de réfraction ;
- éventuellement, dépôt d'une couche hydrophobe.

9. Procédé selon l'une quelconque des revendications 6 à 8, dans lequel le dépôt de la couche à indice de réfraction moyen est réalisé en déposant successivement une première sous-couche à indice de réfraction élevé, puis une seconde sous-couche à faible indice de réfraction.

10. Procédé selon l'une quelconque des revendications 6 à 9, dans lequel le dépôt de la couche d'accroche, qui est une couche en SiO, est effectué par le procédé selon l'une quelconque des revendications 1 à 3.

11. Procédé selon l'une quelconque des revendications 6 à 9, dans lequel le dépôt de la couche et/ou de la sous-couche à faible indice de réfraction, qui est une couche de SiₓO_{y}, est effectué par le procédé de la revendication 4 ou 5.

12. Procédé selon l'une quelconque des revendications 6 à 9, dans lequel le dépôt de la couche et/ou de la sous-couche à indice de réfraction élevée est effectué par évaporation sous vide, éventuellement réactive, d'un oxyde de métal ou de métalloïde, choisi, de préférence, parmi les oxydes de titane, tantale, zirconium, cérium.

13. Procédé selon l'une quelconque des revendications 6 à 9, dans lequel le dépôt de la couche et/ou de la sous-couche à indice de réfraction élevé est effectué par le procédé selon l'une quelconque des revendications 1 à 5.

14. Procédé selon l'une quelconque des revendications 6 à 8, dans lequel le dépôt de la couche à indice de réfraction moyen, qui est une couche de SiₓO_{y} est effectué par le procédé de la revendication 4 ou 5.

15. Procédé selon la revendication 12, dans lequel ledit oxyde est choisi parmi les oxydes de titane Ti₂O₃, TiO₂, TiO.

16. Procédé selon l'une quelconque des revendications 6 à 9, dans lequel le dépôt de la couche et/ou de la sous-couche à faible indice de réfraction est effectué par enduction centrifuge de silice colloïdale ou polymérique, éventuellement suivie d'une densification réticulation.

17. Procédé selon la revendication 16, dans lequel ladite couche à faible indice de réfraction est la couche supérieure au revêtement et possède, en outre, intrinsèquement, des propriétés hydrophobes ; moyennant quoi, le procédé ne comprend pas d'étape de dépôt de couche hydrophobe.

18. Procédé selon l'une quelconque des revendications 6 à 15, dans lequel le dépôt de toutes les couches formant le revêtement optique, à l'exception de la couche hydrophobe éventuelle, est effectué par évaporation sous vide, éventuellement réactive, selon l'une quelconque des revendications 1 à 5.

19. Procédé selon l'une quelconque des revendications 6 à 18, dans lequel le substrat est un substrat organique et qui comprend, en outre, une étape préalable d'application d'un vernis sur le substrat non revêtu.

20. Procédé selon l'une quelconque des revendications 6 à 15 et 18, dans lequel ladite couche hydrophobe est une couche d'un composé silane fluoré, tel que le (Tridécafluoro-1,2,2,2-tétrahydrooctyl)-1-trichlorosilane.

21. Procédé selon l'une quelconque des revendications 1 à 20, dans lequel le dépôt d'au moins une couche, de préférence, de chaque couche est précédé d'un traitement d'activation par plasma.

22. Procédé selon la revendication 21, dans lequel ledit plasma est un plasma à l'argon, haute tension et basse fréquence.

23. Procédé de dépôt d'un revêtement antireflets large bande selon la revendication 8, sur un substrat organique comprenant les étapes successives suivantes :
- dépôt d'une couche de vernis, tel qu'un vernis polysiloxane sur le substrat organique ;
- dépôt d'une première couche, dite couche « d'accroche » en SiO, par évaporation sous vide d'un mélange de poudre de silicium et de poudre de silice par le procédé selon l'une quelconque des revendications 1 à 3 ;
- dépôt d'une deuxième couche à indice de réfraction moyen par dépôts successifs d'une première sous-couche à indice de réfraction élevé, par évaporation réactive sous vide d'un oxyde de métal ou de métalloïde, tel qu'un oxyde de titane, puis dépôt d'une seconde sous-couche de SiₓO_{y} à faible indice de réfraction par évaporation réactive sous vide d'un mélange de poudre de silicium et de poudre de silice par le procédé selon la revendication 4 ou la revendication 5 ; ou par évaporation sous vide réactive d'un mélange de poudre de silicium et de poudre de silice selon la revendication 4 ou la revendication 5 ; l'épaisseur cumulée de la première couche et de la deuxième couche correspondant à un quart de longueur d'onde ;
- dépôt d'une troisième couche à indice de réfraction élevé par évaporation réactive sous vide d'un oxyde de métal ou de métalloïde, tel qu'un oxyde de titane ; ou par évaporation sous vide, éventuellement réactive, d'un mélange de poudre de silicium et de poudre de silice selon l'une quelconque des revendications 1 à 5 ; l'épaisseur de la troisième couche correspondant à une demi longueur d'onde ;
- dépôt d'une quatrième couche de SiₓO_{y} à faible indice de réfraction par évaporation réactive d'un mélange de poudre de silicium et de poudre de silice, selon la revendication 4 ou la revendication 5, l'épaisseur de la quatrième couche correspondant à un quart de longueur d'onde ;
- éventuellement, dépôt d'une couche antiabrasive et/ou hydrophobe, par exemple de silane fluoré.
